(19)

Europäisches
Patentamt
European
Patent Office
Office européen
des brevets

(11) **EP 1 873 920 A1**

(12) **EUROPEAN PATENT APPLICATION**

(43) Date of publication:
**02.01.2008 Bulletin 2008/01**

(51) Int Cl.:
***H03M 13/09*** *(2006.01)*

(21) Application number: **06255310.2**

(22) Date of filing: **16.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **28.06.2006 JP 2006177818**

(71) Applicant: **Fujitsu Ltd.**
**Kawasaki-shi, Kanagawa 211-8588 (JP)**

(72) Inventor: **Kiryu, Ryusuke**
**Kanagawa 211-8588 (JP)**

(74) Representative: **Stebbing, Timothy Charles et al**
**Haseltine Lake**
**Lincoln House**
**300 High Holborn**
**London WC1V 7JH (GB)**

(54) **Memory efficient polynomial division for CRC codes using look-up tables**

(57)     A storing device (51, 104, 106, 205, 207, 209, 211) stores a plurality of remainder tables which respectively hold corresponding remainder information strings by using a plurality of unit information strings as indexes. A table looking-up device (52, 103, 105, 204, 206, 208, 210) obtains a plurality of remainder information strings by partitioning a target information string, which is processed with a loop process performed once, into a plurality of unit information strings and by referring to the plurality of remainder tables with the use of the unit information strings as indexes. A calculating device (53, 107, 203, 212) calculates an exclusive OR of the obtained plurality of remainder information strings and the first information string of an unprocessed portion of an input information string. The table looking-up device repeats a reference of the plurality of remainder tables a predetermined number of times by using the obtained information string of the exclusive OR as a target information string in the next loop process.

FIG. 2

**Description**

The present invention relates to an apparatus for calculating a remainder of an input information string in cyclic redundancy check (CRC) coding or error detection of a CRC code.

In conventional CRC coding or error detection of a CRC code, a remainder calculation for obtaining a remainder by dividing a polynomial, which corresponds to an input bit stream, by a generator polynomial is made (for example, see the following Patent Documents 1 and 2).
Patent Document 1: Japanese Patent Application Publication No. 2005-006188
Patent Document 2: International Publication of PCT International Application WO/2003/090362

If a remainder calculation using a generator polynomial $G(x)$ of the degree of M for a code bit stream P of K bits is implemented with a multi-bit process by t bits, a remainder table that records a bit stream R of M bits, which represents a remainder for an arbitrary bit stream p of the number of bits t, is prepared.

In this case, assuming that polynomials, which respectively correspond to the bit streams p and R, are $p(x)$ and $R(x)$ respectively, $R(x)$ represents a remainder left when $p(x) \cdot x^M$ is divided by $G(x)$. P, $G(x)$, p, $p(x)$, R and $R(x)$ are respectively defined by the following equations.

$$P = b_0, \ b_1, \ b_2, \ldots, \ b_{K-1} \tag{1}$$

$$G(x) = a_0 \cdot x^M + a_1 \cdot x^{M-1} + \cdots + a_M \cdot x^0 \tag{2}$$

$$p = b_0, \ b_1, \ b_2, \ldots, \ b_{t-1} \tag{3}$$

$$\begin{aligned} p(x) &= b_0 \cdot x^{t-1} + b_1 \cdot x^{t-2} + b_2 \cdot x^{t-3} + \cdots + b_{t-1} \cdot x^0 \\ &= \{ b_0, \ b_1, \ b_2, \ldots, \ b_{t-1} \} \end{aligned} \tag{4}$$

$$R = r_0, \ r_1, \ r_2, \ldots, \ r_{M-1} \tag{5}$$

$$\begin{aligned} R(x) &= r_0 \cdot x^{M-1} + r_1 \cdot x^{M-2} + r_2 \cdot x^{M-3} + \cdots + r_{M-1} \cdot x^0 \\ &= \{ r_0, \ r_1, \ r_2, \ldots, \ r_{M-1} \} \end{aligned} \tag{6}$$

The bits of these bit streams take a logic value 0 or 1. With a sequential process by t bits, which uses the above described remainder table, a remainder calculation for the input bit stream P is made.

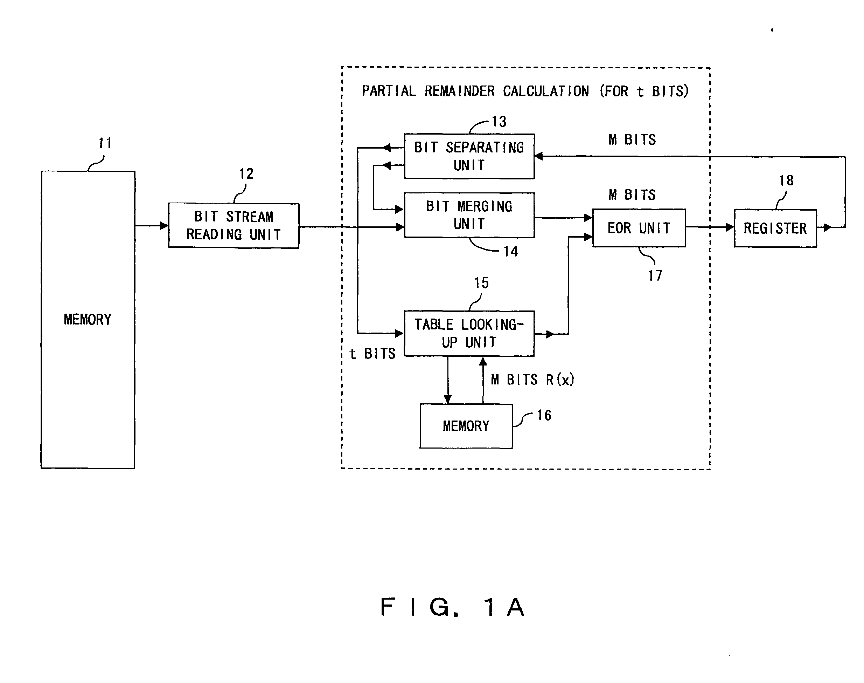

Fig. 1A is a block diagram showing the configuration of a remainder calculating apparatus for making such a remainder calculation. This remainder calculating apparatus comprises memories 11 and 16, a bit stream reading unit 12, a bit separating unit 13, a bit merging unit 14, a table looking-up unit 15, an exclusive OR (EOR) unit 17, and a register 18.

The input bit stream P of K bits, for which the remainder calculation is to be made, is stored in the memory 11, whereas a remainder table RTable[] of p (x)· x^M is stored in the memory 16. Initially, the first M bits of the input bit stream P are stored in the register 18 of M bits as R'.

$$R' = r'_0, \; r'_1, \; r'_2, \ldots, \; r'_{M-1}$$
$$\leftarrow b_0, \; b_1, \; b_2, \ldots, \; b_{M-1} \tag{7}$$

Thereafter, the following partial remainder calculation for t bits is repeated a predetermined number of times.
First of all, the bit separating unit 13 extracts the first t bits $r'_0, r'_1, r'_2, \ldots, r'_{t-1}$ of the register 18, and the table looking-up unit 15 obtains a table lookup result R of M bits by making the table lookup of RTable[] in the memory 16.

$$R \leftarrow RTable[r'_0, \; r'_1, \; r'_2, \ldots, \; r'_{t-1}] \tag{8}$$

The bit stream reading unit 12 reads succeeding t bits of the input bit stream P from the memory 11, and outputs the read bit stream to the bit merging unit 14 as p.

$$p \leftarrow b_{(i-1)t+M}, \; b_{(i-1)t+M+1}, \ldots, \; b_{it+M-1} \; (i=1,2,\ldots) \tag{9}$$

The bit merging unit 14 generates a bit stream R" of M bits by linking p to the last (M-t) bits $r'_t, r'_{t+1}, \ldots, r'_{M-1}$ of the register 18.

$$R'' \leftarrow r'_t, \; r'_{t+1}, \ldots, \; r'_{M-1}, \; p$$
$$= r'_t, \; r'_{t+1}, \ldots, \; r'_{M-1}, \; b_{(i-1)t+M}, \; b_{(i-1)t+M+1}, \ldots, \; b_{it+M-1} \tag{10}$$

The EOR unit 17 calculates an EOR (denoted as "+") of R" and R, and stores a calculation result in the register 18 as R'.

$$R' \leftarrow R + R'' \tag{11}$$

R' obtained by repeating the above described partial remainder calculation the predetermined number of times becomes a remainder calculation result for the input bit stream P.

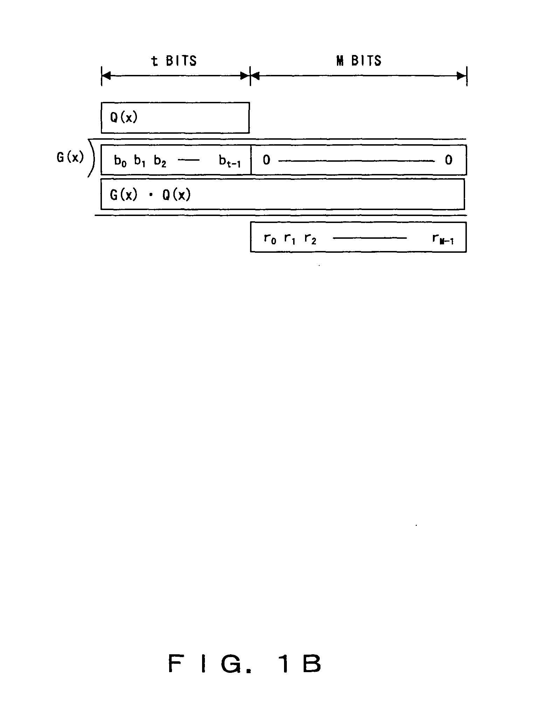

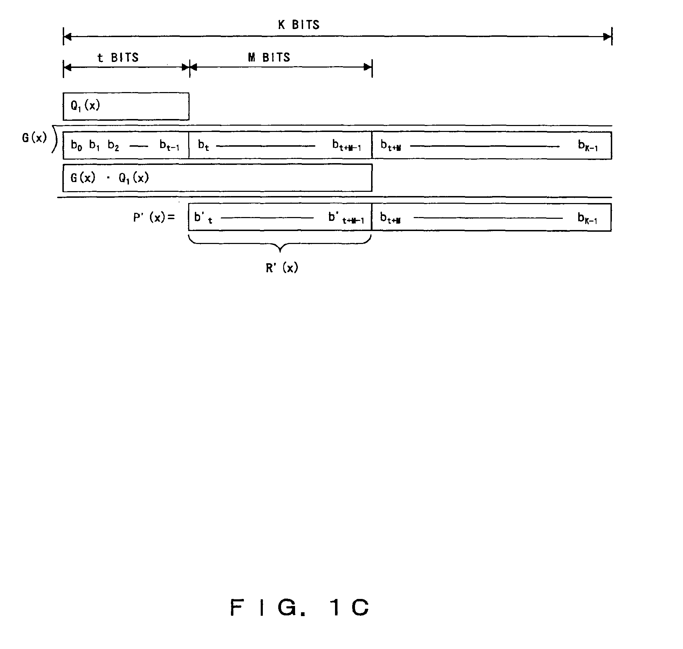

Fig. 1B shows a method for creating RTable [] in the memory 16. In this example, R(x)={$r_0, r_1, r_2, \ldots, r_{M-1}$} is put into a table for each p(x)={$b_0, b_1, b_2, \ldots, b_{t-1}$}.

$$RTable[b_0, \; b_1, \; b_2, \ldots, \; b_{t-1}]$$
$$= MOD(\{b_0, \; b_1, \; b_2, \ldots, \; b_{t-1}\} \cdot x^M, \; G(x)) \tag{12}$$

The size of one element of RTable[] is M bits, and the number of elements is $2^t$. Accordingly, the size of the entire table is M·$2^t$ Q(x) in Fig. 1B represents a polynomial of a quotient.

Fig. 1C shows a process for t bits, which uses RTable[]. A process result R' is obtained with the remainder calculation for the first t bits of P=bo, $b_1$, $b_2$, ... , $b_{K-1}$.

$$R'=b'_t,\ b'_{t+1},\ldots,\ b'_{t+M-1} \tag{13}$$

R' of M bits is equivalent to, what is called, a CRC register at the time of a CRC calculation. This R' can be easily obtained with the table lookup of RTable[] and the EOR calculation.

$$\begin{aligned}R'(x) &=MOD(\{b_0,\ b_1,\ldots,\ b_{t+M-1}\},\ G(x))\\ &=MOD(\{b_0,\ b_1,\ldots,\ b_{t-1}\}\cdot x^M,\ G(x))+\{b_t,\ b_{t+1},\ldots,\ b_{t+M-1}\}\\ &=RTable[b_0,\ b_1,\ldots,\ b_{t-1}]+\{b_t,\ b_{t+1},\ldots,\ b_{t+M-1}\}\\ &=\{r_0,\ r_1,\ldots,\ r_{M-1}\}+\{b_t,\ b_{t+1},\ldots,\ b_{t+M-1}\}\\ &=\{b'_t,\ b'_{t+1},\ldots,\ b'_{t+M-1}\}\end{aligned} \tag{14}$$

Assuming that the bit stream to be processed subsequently is P', a polynomial P' (x) becomes as the following equation.

$$\begin{aligned}P'(x) &=R'(x)\cdot x^{(K-1)-(t-M-1)}+\{b_{t+M},\ b_{t+M+1},\ldots,\ b_{K-1}\}\\ &=\{b'_t,\ b'_{t+1},\ldots,\ b'_{t+M-1},\ b_{t+M},\ b_{t+M+1},\ldots,\ b_{K-1}\}\end{aligned} \tag{15}$$

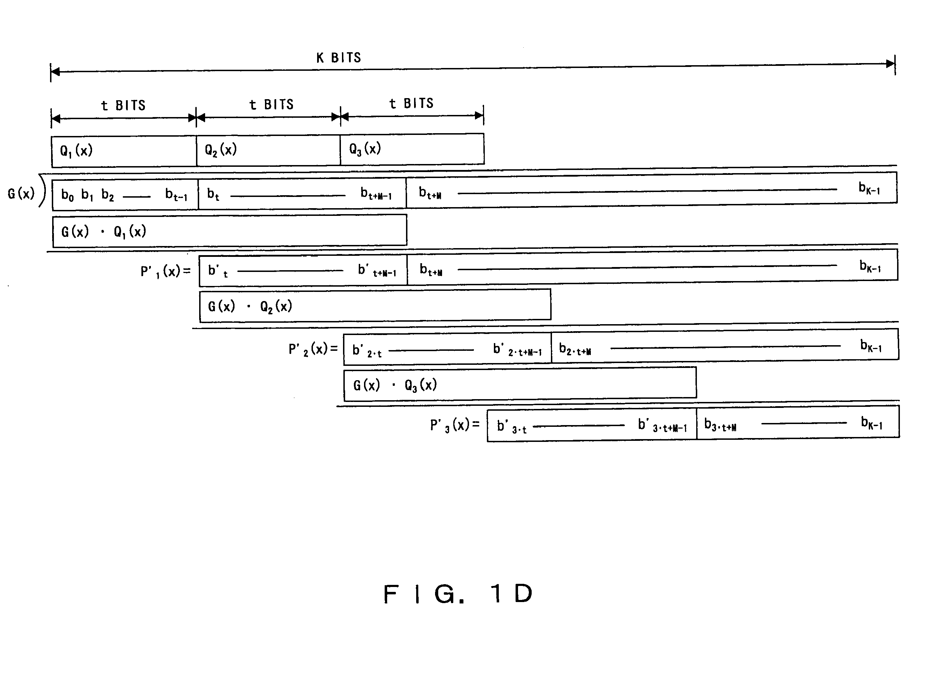

As shown in Fig. 1D, the process is repeated by regarding P' as a new P, so that a remainder for n·t bits is calculated with the process repeated n times. Accordingly, R' (x) obtained with the process repeated K/t times becomes a remainder calculation result for the input bit stream P of K bits. In Fig. 1D, the process repeated three times is shown.

For CRC coding, R' (x) is used as parity bits. If R'(x) is other than 0 at the time of error detection of a CRC code, this means that an error exists.

With the above described conventional remainder calculation, the size of a remainder table required for the process by t bit is M·$2^t$ bits. Since the size of the table exponentially increases with the value of t, t cannot be set to a large value.

Accordingly, it is desirable to reduce the size of a remainder table required for a partial remainder calculation in CRC coding or error detection of a CRC code.

A remainder calculating apparatus according to the present invention comprises a storing device, a table looking-up device, and a calculating device. This apparatus calculates a remainder left when a polynomial corresponding to an input information string is divided by a generator polynomial.

The storing device stores a plurality of remainder tables which respectively hold the values of corresponding remainder information strings by using the respective values of a plurality of unit information strings as indexes. The table looking-up device partitions a target information string, which is processed with a loop process performed once, into a plurality of unit information strings, refers to the plurality of remainder tables by using the respective values of the unit information strings as indexes, and obtains the values of a plurality of remainder information strings. The calculating device calculates an exclusive OR of the obtained plurality of remainder information strings and the first information string of an unprocessed portion of the input information string.

The table looking-up device repeats a reference of the plurality of remainder tables a predetermined number of times by using the obtained information string of the exclusive OR as a target information string in a loop process to be performed next.

Reference is made, by way of example only, to the accompanying drawings in which:

Fig. 1A is a block diagram showing the configuration of a conventional remainder calculating apparatus;
Fig. 1B shows a method for creating a conventional remainder table;
Fig. 1C shows a conventional process for t bits;
Fig. 1D shows a conventional process repeated;
Fig. 2 is a block diagram showing the principle of a remainder calculating apparatus according to the present invention;
Fig. 3 shows a method for creating a first remainder table;
Fig. 4 shows a method for creating a second remainder table;
Fig. 5 shows a method for creating an Nth remainder table;
Fig. 6 shows a remainder calculation using N remainder tables;
Fig. 7 shows a table lookup of the first remainder table;
Fig. 8 shows a table lookup of the second remainder table;
Fig. 9 shows a table lookup of the Nth remainder table;
Fig. 10A shows a process for t bits;
Fig. 10B shows a process repeated;
Fig. 11 is a block diagram showing the configuration of a first remainder calculating apparatus;
Fig. 12 is a block diagram showing the configuration of a second remainder calculating apparatus;
Fig. 13 is a block diagram showing the configuration of an information processing device; and
Fig. 14 shows a method for providing a program and data.

Preferred embodiments for implementing the present invention are described in detail below with reference to the drawings.

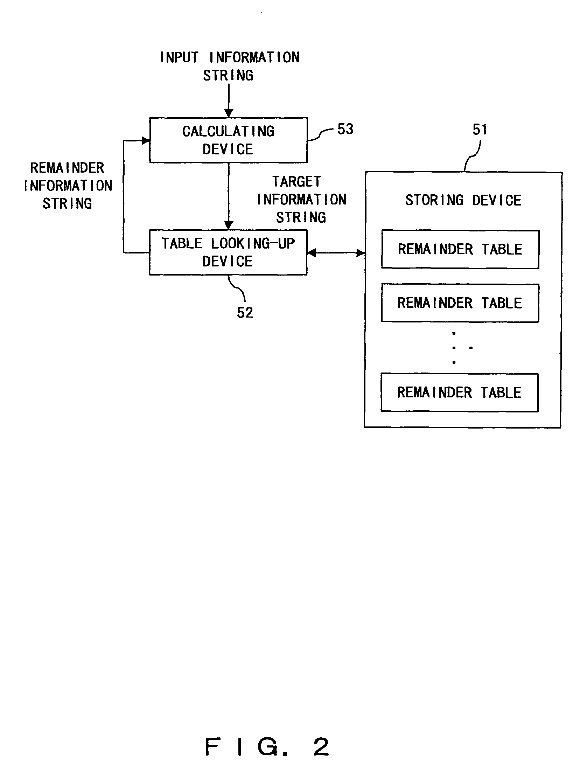

Fig. 2 is a block diagram showing the principle of a remainder calculating apparatus according to the present invention. The remainder calculating apparatus shown in Fig. 2 comprises a storing device 51, a table looking-up device 52, and a calculating device 53. This apparatus calculates a remainder left when a polynomial corresponding to an input information string is divided by a generator polynomial.

The storing device 51 stores a plurality of remainder tables which respectively hold the values of corresponding remainder information strings by using the respective values of a plurality of unit information strings as indexes. The table looking-up device 52 partitions a target information string, which is processed with a loop process performed once, into a plurality of unit information strings, refers to the plurality of remainder tables by using the respective values of the unit information strings as indexes, and obtains the values of a plurality of remainder information strings. The calculating device 53 calculates an exclusive OR of the obtained plurality of remainder information strings and the first information string of an unprocessed portion of the input information string.

The table looking-up device 52 repeats referring to the plurality of remainder tables a predetermined number of times by using the obtained information string of the exclusive OR as a target information string in a loop process to be performed next.

The input information string is partitioned by the same length as the target information string sequentially from the beginning, and input to the calculating device 51. The calculating device 51 calculates an exclusive OR of the plurality of remainder information strings obtained with the preceding loop process and the input information string yet to be processed, and outputs the calculated exclusive OR to the table looking-up device 52 as a target information string. The table looking-up device 52 partitions the received target information string into a plurality of unit information strings, and refers to the plurality of remainder tables by using the respective values of the unit information strings as indexes. The obtained plurality of remainder information strings are output to the calculating device 51, and used in the loop process to be performed next.

Such a loop process is repeated, whereby a remainder calculation result for the input information string is obtained.

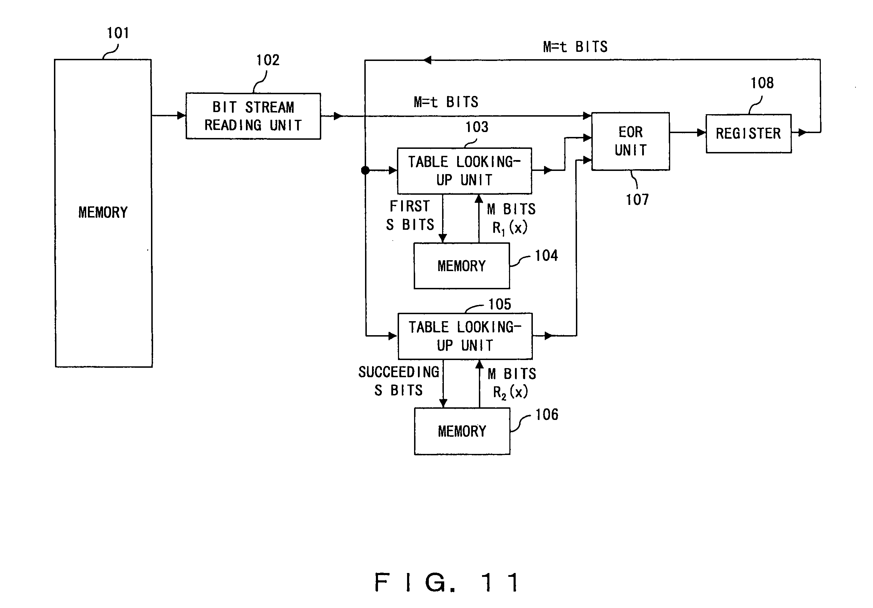

For example, in a remainder calculating apparatus that is shown in Fig. 11 and will be described later, the storing device 51 corresponds to memories 104 and 106, the table looking-up device 52 corresponds to table looking-up units 103 and 105, and the calculating device 53 corresponds to an EOR unit 107.

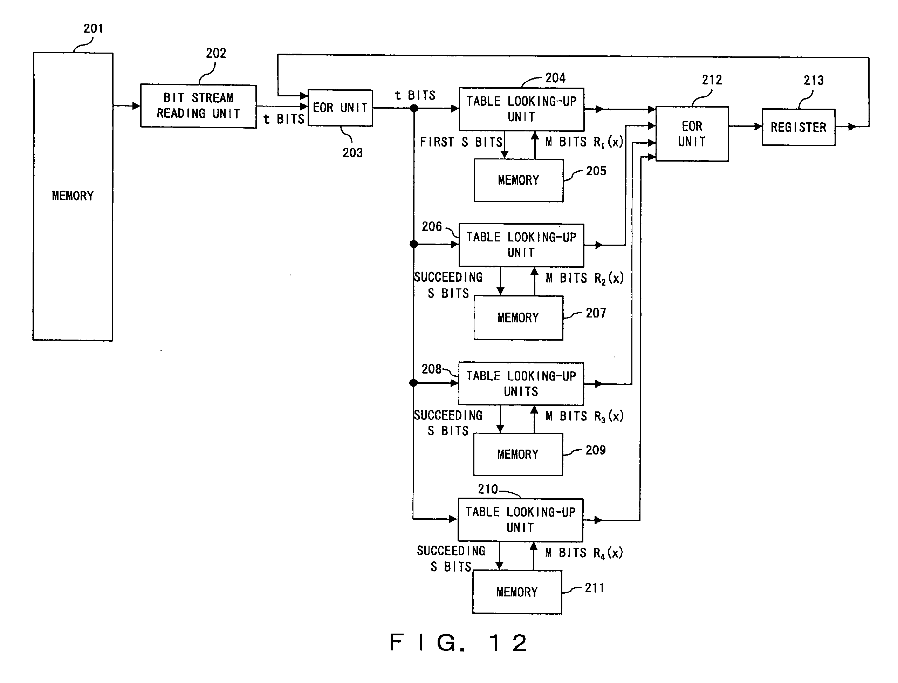

Additionally, in a remainder calculating apparatus shown in Fig. 12, the storing device 51 corresponds to memories 205, 207, 209, and 211, the table looking-up device 52 corresponds to table looking-up units 204, 206, 208 and 210, and the calculating device 53 corresponds to EOR units 203 and 212.

Assume that the length of the target information string, the length of the remainder information string, the number of partitions of the target information string, and the length of the unit information string are $t$, $M$, $N$, and $s$ $(=t/N)$ respectively. In this case, the size of one element of each remainder table is $M$ bits, and the number of elements is $2^s$. Accordingly, the total size of N tables becomes $N \cdot M \cdot 2^s$. If $N \geq 2$ and $s \geq 2$, a ratio of the total size when the N tables of $M \cdot 2^s$ bits are prepared to that when one table of $M \cdot 2^t$ bits is prepared becomes as the following equation.

$$(N \cdot M \cdot 2^s) / (M \cdot 2^t) = N \cdot 2^s / 2^{Ns} < 1 \qquad (21)$$

Therefore, comparing with the conventional remainder table, the table size can be reduced as a whole, and the length t of the target information string, which is processed with the loop process performed once, can be set to a large value. For example, if t=32 and N=4, s=8. Therefore, the table size is reduced to $(M \cdot 2^s \cdot N)/(M \cdot 2^t) = 1/2^{22}$.

The remainder calculating apparatus according to the preferred embodiment is implemented, for example, with a processor having a plurality of execution units, or a processor that requires a latency cycle in order to refer to a memory.

Additionally, a parameter s which represents t/N is introduced, and the N remainder tables are prepared instead of preparing a remainder of $p(x) \cdot x^M$, which corresponds to an arbitrary bit stream p of the number of bits t, as a table. At this time, a polynomial corresponding to an arbitrary bit stream p' of the number of bits s is defined to be p' (x), and remainders of $p'(x) \cdot x^{M+(N-1)s}$, $p'(x) \cdot x^{M+(N-2)s}$,..., $p'(x) \cdot x^{M+s}$, and $p'(x) \cdot x^M$ are registered to tables RTable1 [], RTable2 [] , ... , RTable (N-1) [ ], and RTableN[] respectively. p' and p'(x) are respectively defined with the following equations.

$$p' = b'_0, \ b'_1, \ b'_2, \ldots, \ b'_{s-1} \qquad (22)$$

$$p'(x) = b'_0 \cdot x^{s-1} + b'_1 \cdot x^{s-2} + b'_2 \cdot x^{s-3} + \cdots + b'_{s-1} \cdot x^0$$
$$= \{b'_0, \ b'_1, \ b'_2, \ldots, \ b'_{s-1}\} \qquad (23)$$

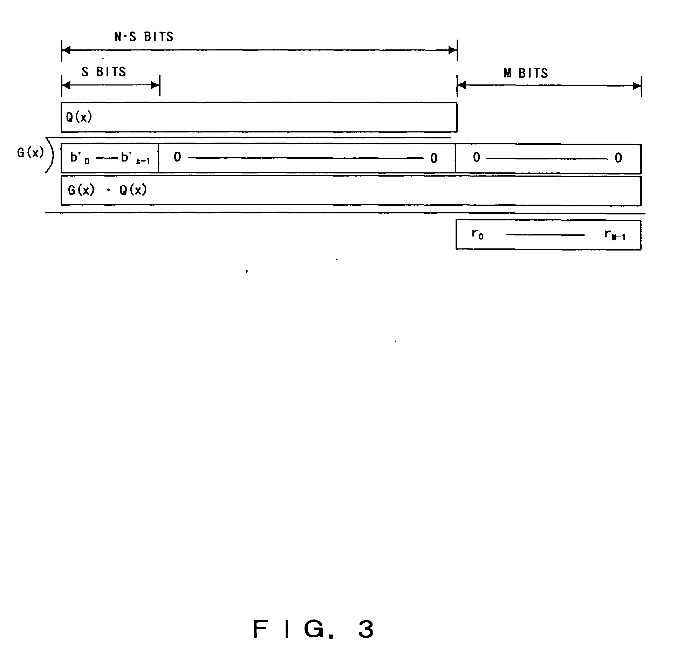

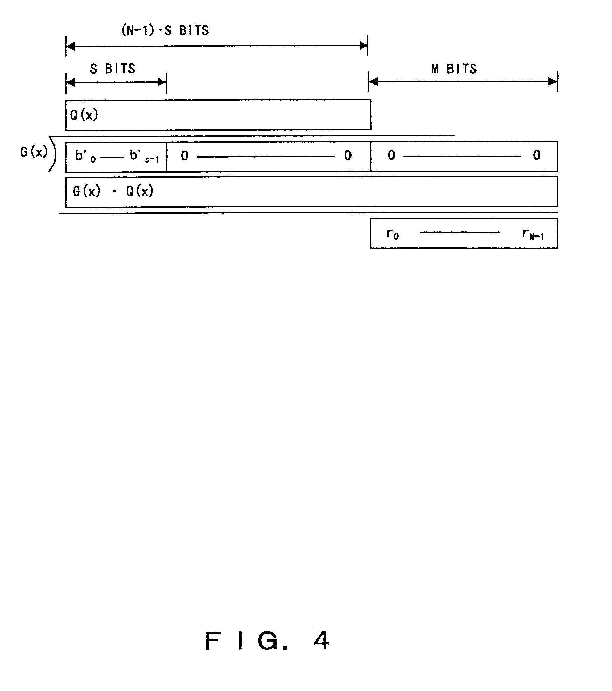

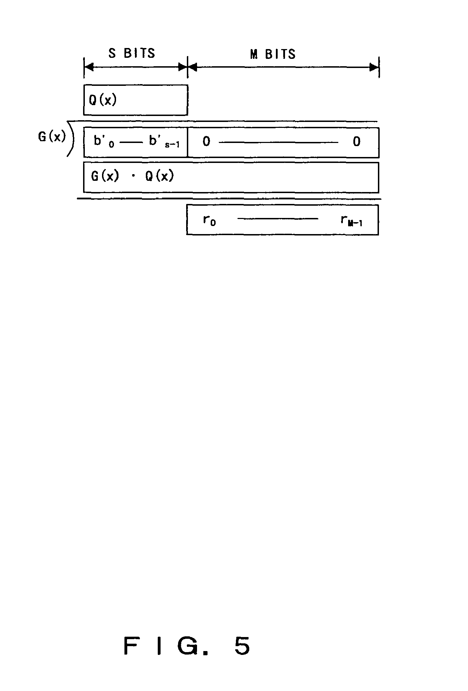

Figs. 3, 4, and 5 respectively show a method for creating RTable1[], RTable2[] and RTableN[]. In this example, $R(x) = \{r_0, r_1, r_2, \ldots, r_{M-1}\}$ is put into a table for each $p'(x) = \{b'_0, b'_1, b'_2, \ldots, b'_{s-1}\}$.

$$RTable1[b'_0, \ b'_1, \ b'_2, \ldots, \ b'_{s-1}]$$
$$= MOD(\{b'_0, \ b'_1, \ b'_2, \ldots, \ b'_{s-1}\} \cdot x^{M+(N-1)s}, \ G(x)) \qquad (24)$$

$$RTable2[b'_0, \ b'_1, \ b'_2, \ldots, \ b'_{s-1}]$$
$$= MOD(\{b'_0, \ b'_1, \ b'_2, \ldots, \ b'_{s-1}\} \cdot x^{M+(N-2)s}, \ G(x)) \qquad (25)$$

$$RTableN[b'_0, \ b'_1, \ b'_2, \ldots, \ b'_{s-1}]$$
$$= MOD(\{b'_0, \ b'_1, \ b'_2, \ldots, \ b'_{s-1}\} \cdot x^M, \ G(x)) \qquad (26)$$

The size of one element of each of the remainder tables is M bits, and the number of elements is $2^s$. Accordingly, the total size of all of the N tables is $N \cdot M \cdot 2^s$.

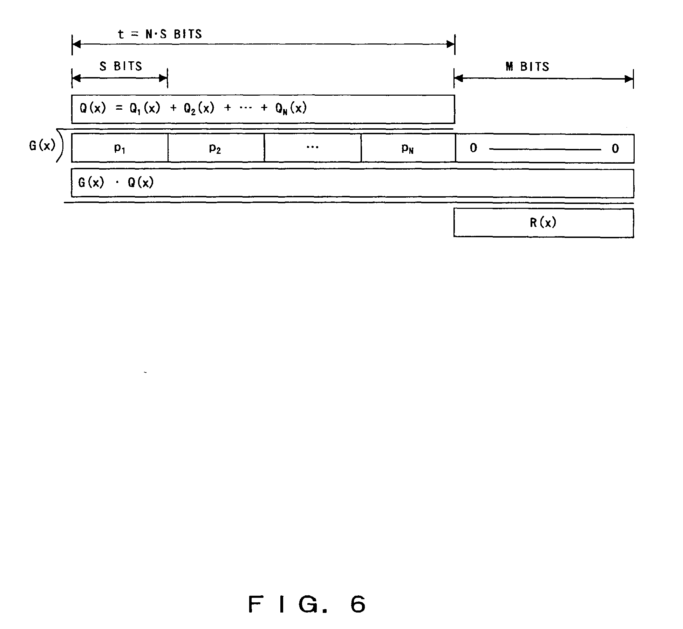

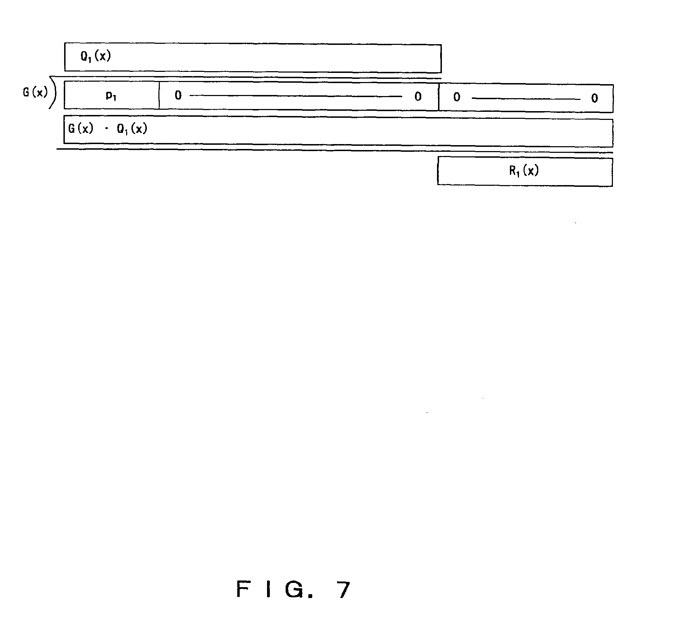

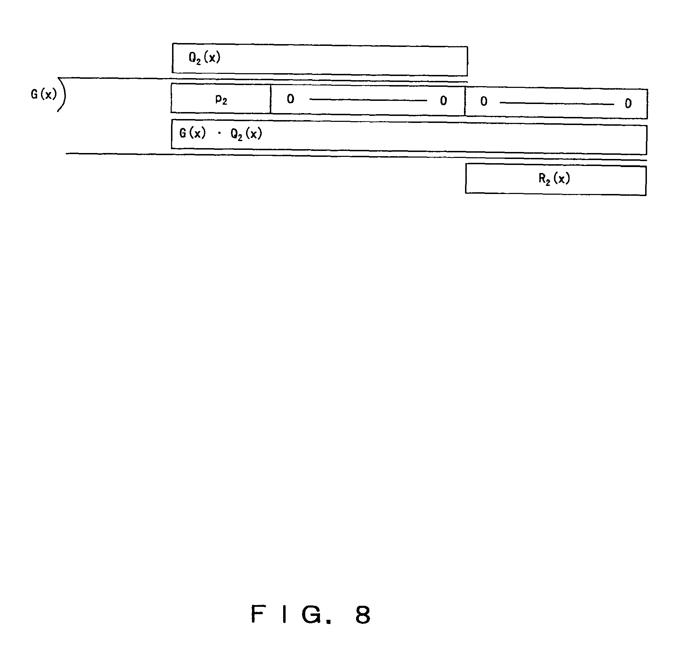

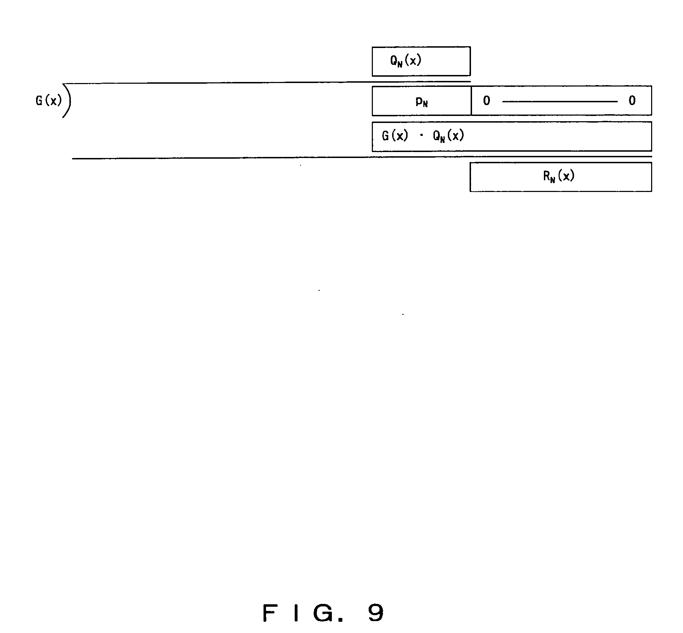

Fig. 6 shows a remainder calculation using the N remainder tables. Figs. 7, 8, and 9 show the look-up of RTable1[], RTable2[], and RTableN[] respectively.

The table look-up of RTable1[] is made by using the bit stream $p_1$ of the first s bits of the bit stream p of t bits as an index, thereby obtaining $R_1$. Also the table look-up of RTable2[], ..., RTableN[] is made by using succeeding bit streams $p_2$, ..., $p_N$ of s bits, thereby obtaining $R_2$, ..., $R_N$ respectively.

$$p(x) = p_1(x) \cdot x^{(N-1)s} + p_2(x) \cdot x^{(N-2)s} + \cdots + p_N(x) \tag{27}$$

$$R_1(x) = RTable1[p_1]$$
$$R_2(x) = RTable1[p_2]$$
$$\cdots$$
$$R_N(x) = RTable1[p_N] \tag{28}$$

Then, a remainder $R(x)$ of $p(x) \cdot x^M$ is obtained with the following equation.

$$R(x) = R_1(x) + R_2(x) + \cdots + R_N(x) \tag{29}$$

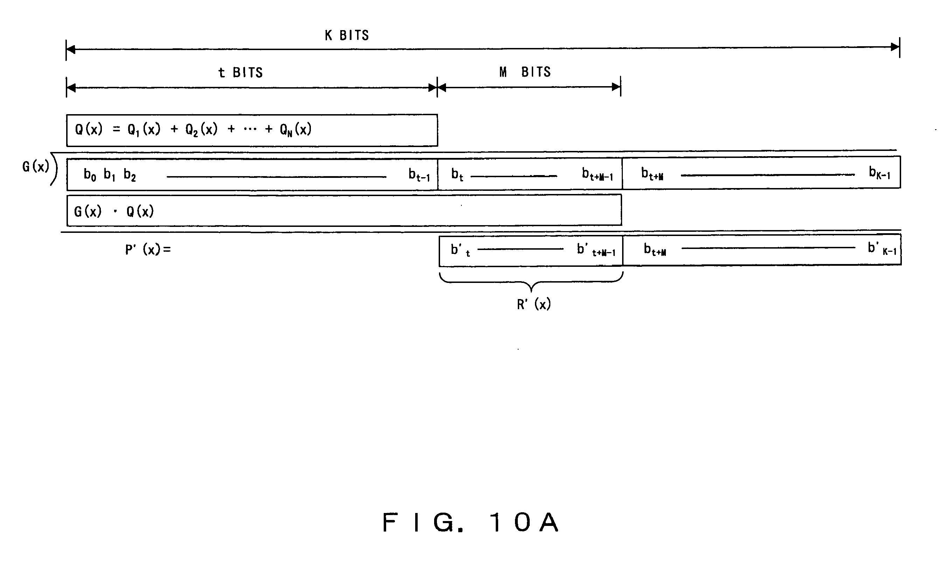

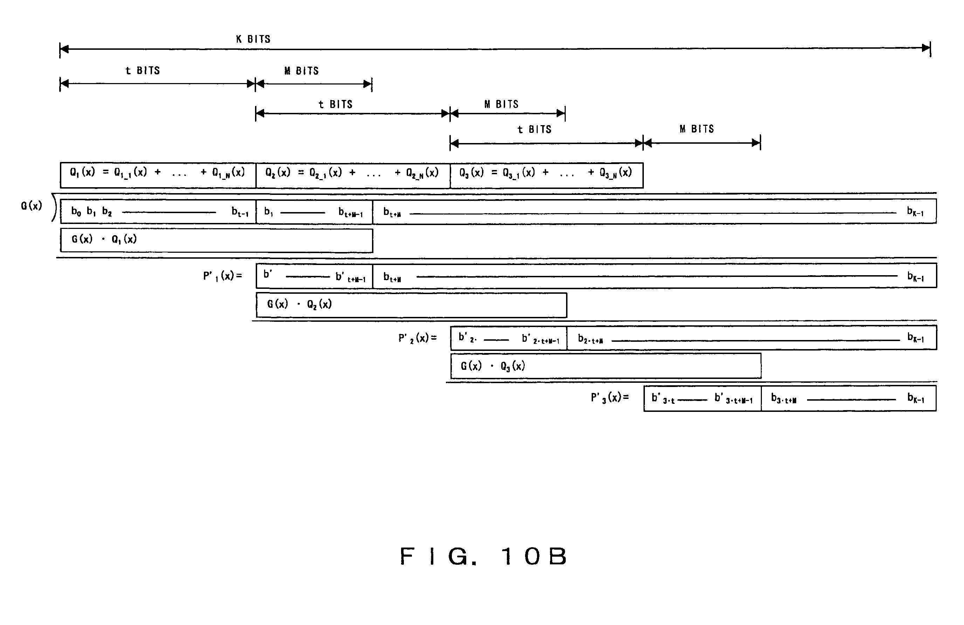

Fig. 10A shows a process for t bits, which uses the N remainder tables. A process result $R'$ is obtained with the remainder calculation for the first t bits of $P = b_0, b_1, b_2, \ldots, b_{K-1}$.

$$R' = b'_t, \ b'_{t+1}, \ldots, \ b'_{t+M-1} \tag{30}$$

This $R'$ can be obtained easily with the table look-up of RTable1[] to RTableN[] and an EOR calculation.

$$\begin{aligned}
R'(x) = &MOD(\{b_0, \ b_1, \ldots, \ b_{t-1}\} \cdot x^M, \ G(x)) + \{b_t, \ b_{t+1}, \ldots, \ b_{t+M-1}\} \\
= &R(x) + \{b_t, \ b_{t+1}, \ldots, \ b_{t+M-1}\} \\
= &RTable1[b_0, \ b_1, \ldots, \ b_{s-1}] \\
&+ RTable2[b_s, \ b_{s+1}, \ldots, \ b_{2s-1}] + \cdots \\
&+ RTableN[b_{(N-1)s}, \ b_{(N-1)s+1}, \ldots, \ b_{Ns-1}] \\
&+ \{b_t, \ b_{t+1}, \ldots, \ b_{t+M-1}\} \tag{31}
\end{aligned}$$

Assuming that a bit stream to be processed subsequently is P', the polynomial $P'(x)$ becomes as the following equation.

$$\begin{aligned}
P'(x) = &R'(x) \cdot x^{(K-1)-(t-M-1)} + \{b_{t+M}, \ b_{t+M+1}, \ldots, \ b_{K-1}\} \\
= &\{b'_t, \ b'_{t+1}, \ldots, \ b'_{t+M-1}, \ b_{t+M}, \ b_{t+M+1}, \ldots, \ b_{K-1}\} \tag{32}
\end{aligned}$$

The process is repeated by regarding P' as a new P as shown in Fig. 10B, whereby a remainder for n·t bits is calculated with the process repeated n times. In Fig. 10B, the process repeated three times is shown.
An example of the configuration of the remainder calculating apparatus using such remainder tables is described next with reference to Figs. 11 and 12.

Fig. 11 shows an example of the configuration of the remainder calculating apparatus when M=16, t=16, N=2, and s=8. This remainder calculating apparatus comprises memories 101, 104 and 106, a bit stream reading unit 102, table looking-up units 103 and 105, an EOR unit 107, and a register 108.

An input bit stream P of K bits, for which the remainder calculation is to be made, is stored in the memory 101, a remainder table RTable1[] of $p'(x) \cdot x^{M+s}$ is stored in the memory 104, and a remainder table RTable2[] of $p'(x) \cdot x^M$ is stored in the memory 106.

The bit stream reading unit 102 reads the bit stream P stored in the memory 101 by t bits (16 bits) sequentially from the beginning, and outputs the read string to the EOR unit 107. The table looking-up unit 103 obtains the bit stream of a remainder $R_1(x)$ by making the table lookup of RTable1[] with the use of the first s bits (8 bits) of the value of the register 108 of M bits (16 bits), and outputs the obtained bit stream to the EOR unit 107. The table looking-up unit 105 obtains the bit stream of a remainder $R_2(x)$ by making the table lookup of RTable2[] with the use of the remaining s bits (8 bits) of the value of the register 108, and outputs the obtained bit stream to the EOR unit 107.

The EOR unit 107 calculates an EOR of the bit stream received from the bit stream reading unit 102 and the bit streams of $R_1(x)$ and $R_2(x)$, and stores a calculation result in the register 108.

The above described process is performed by setting all bits of the initial value of the register 108 to 0, whereby the first 16 bits of the bit stream P are stored in the register 108. Thereafter, the above described process is repeated K/t times for the remaining bit stream of the bit stream P, whereby the remainder calculation result for the input bit stream P is stored in the register 108. Note that, however, a bit stream where all of bits are 0 is output from the bit stream reading unit 102 to the EOR unit 107 in the last loop. By using the remainder calculation result stored in the register 108, CRC coding or error detection of a CRC code is made.

With a processor that comprises a plurality of execution units and can refer to a memory twice during one instruction cycle, or a processor that requires a latency cycle in order to refer to a memory, the table look-up processes by the table looking-up units 103 and 105 can be also performed without increasing the number of processing cycles during one loop for t bits.

Additionally, a memory area required for the remainder tables is reduced from the conventional $2^{20}$ (=M·$2^t$) bits to $2^{13}$ (=M·$2^s$·N) bits.

Fig. 12 shows an example of the configuration of the remainder calculating apparatus when M=16, t=32, N=4, and s=8. This remainder calculating apparatus comprises memories 201, 205, 207, 209 and 211, a bit stream reading unit 202, EOR units 203 and 212, table looking-up units 204, 206, 208 and 210, and a register 213.

An input bit stream P of K bits, for which the remainder calculation is to be made, is stored in the memory 201, a remainder table RTable1 [] of $p'(x) \cdot x^{M+3s}$ is stored in the memory 205, and a remainder table RTable2[] of $p'(x) \cdot x^{M+2s}$ is stored in the memory 207. Additionally, a remainder table RTable3[] of $p'(x) \cdot x^{M+s}$ is stored in the memory 209, and a remainder table RTable4[] of $p'(x) \cdot x^M$ is stored in the memory 211.

The bit stream reading unit 202 reads the bit stream P stored in the memory 201 by t bits (32 bits) sequentially from the beginning, and outputs the read string to the EOR unit 203. The EOR unit 203 calculates an EOR of the bit stream received from the bit stream reading unit 202 and the value of the register 213 of M bits (16 bits) by aligning the strings to the beginning.

At this time, a bit stream of 16 bits, all of which are 0, is appended to the register value of 16 bits to generate a bit stream of 32 bits, and an EOR of this bit stream and the bit stream output from the bit stream reading unit 202 is calculated. Then, the EOR unit 203 outputs a calculation result of t bits (32 bits) to the table looking-up units 204, 206, 208, and 210.

The table looking-up unit 204 obtains the bit stream of a remainder $R_1(x)$ by making the table lookup of RTable1 [] with the use of the first s bits (8 bits) of the bit stream received from the EOR unit 203, and outputs the obtained bit stream to the EOR unit 212. The table looking-up unit 206 obtains the bit stream of a remainder $R_2(x)$ by making the table lookup of RTable2 [] with the use of the succeeding s bits (8 bits), and outputs the obtained bit stream to the EOR unit 212.

The table looking-up unit 208 obtains the bit stream of a remainder $R_3(x)$ by making the table lookup of RTable3 [] with the use of the further succeeding s bits (8 bits), and outputs the obtained bit stream to the EOR unit 212. The table looking-up unit 210 obtains the bit stream of a remainder $R_4(x)$ by making the table lookup of RTable4[] with the use of the last s bits (8 bits), and outputs the obtained bit stream to the EOR unit 212.

The EOR unit 212 calculates an EOR of the bit streams of $R_1(x)$, $R_2(x)$, $R_3(x)$ and $R_4(x)$, and stores a calculation result in the register 213.

The above described process is repeated K/t times by setting all bits of the initial value of the register 213 to 0, whereby a remainder calculation result for the input bit stream P is stored in the register 213. Then, CRC coding or error detection of a CRC code is made by using the remainder calculation result stored in the register 213.

With a processor having a plurality of execution units and can refer to a memory a plurality of times during one instruction cycle, or a processor that requires a latency cycle in order to refer to a memory, the table look-up processes by the plurality of table looking-up units can be also performed without increasing the number of processing cycles during one loop for t bits.

Additionally, a memory area required for the remainder tables is reduced from the conventional $2^{36}$ (=M·$2^t$) bits to $2^{14}$ (=M·$2^s$·N) bits.

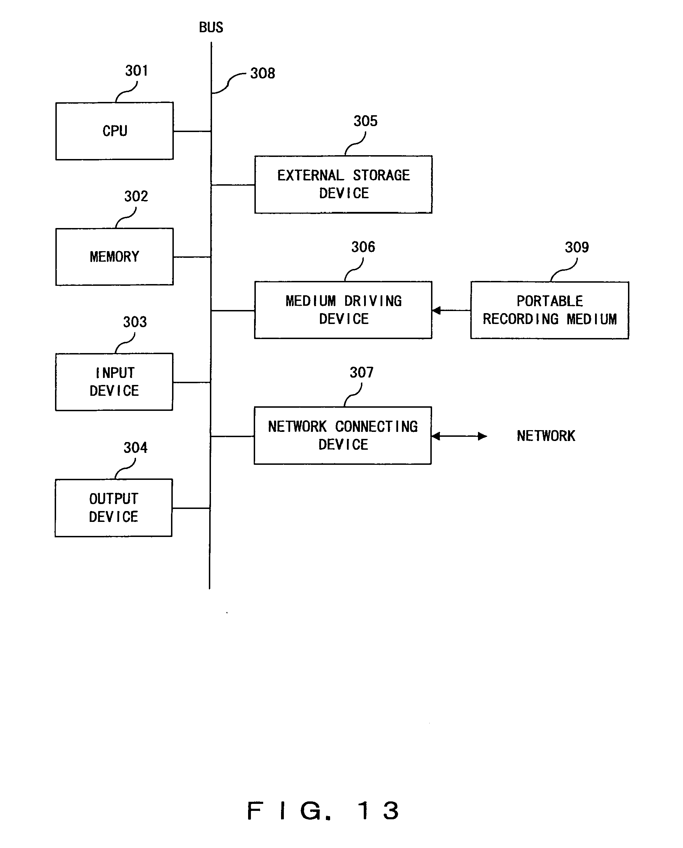

The remainder calculating apparatuses shown in Figs. 11 and 12 are configured, for example, with an information processing device (computer) shown in Fig. 13. The information processing device shown in Fig. 13 comprises a CPU (Central Processing Unit) 302, a memory 302, an input device 303, an output device 304, an external storage device 305, a medium driving device 306, and a network connecting device 307, which are interconnected by a bus 308.

The memory 302 includes, for example, a ROM (Read Only Memory), a RAM (RandomAccess Memory), etc., and stores a program and data, which are used for processes. The CPU 301 performs various processes including the above described remainder calculation by executing the program with the memory 302.

In this case, the memories 101, 104 and 106 of Fig. 11, and the memories 201, 205, 207, 209 and 211 of Fig. 12 correspond to the memory 302. The bit stream reading unit 102, the table looking-up units 103 and 105, and the EOR unit 107 of Fig. 11, and the bit stream reading unit 202, the EOR units 203 and 212, and the table looking-up units 204, 206, 208, and 210 of Fig. 12 correspond to the program stored in the memory.

The input device 303 is, for example, a keyboard, a pointing device, etc., and used to input an instruction or information from an operator. The output device 304 is, for example, a display, a printer, a speaker, etc., and used to output an inquiry or a process result to an operator.

The external storage device 305 is, for example, a magnetic disk device, an optical disk device, a magneto-optical disk device, a tape device, etc. The information processing device stores the program and the data onto this external storage device 305, and as occasion demands, loads the program and the data into the memory 302 and uses them.

The medium driving device 306 drives a portable recording medium 309, and accesses its recorded contents. The portable recording medium 309 is an arbitrary computer-readable recording medium such as a memory card, a flexible disk, an optical disk, a magneto-optical disk, etc. An operator stores the program and the data onto this portable recording medium 309, and as occasion demands, loads the program and the data into the memory 302 and uses them.

The network connecting device 307 is connected to a communications network, and transmits/receives a bit stream including a CRC code. As occasion demands, the information processing device receives the program and the data from an external device via the network connecting device 307, loads the program and the data into the memory 302, and uses them.

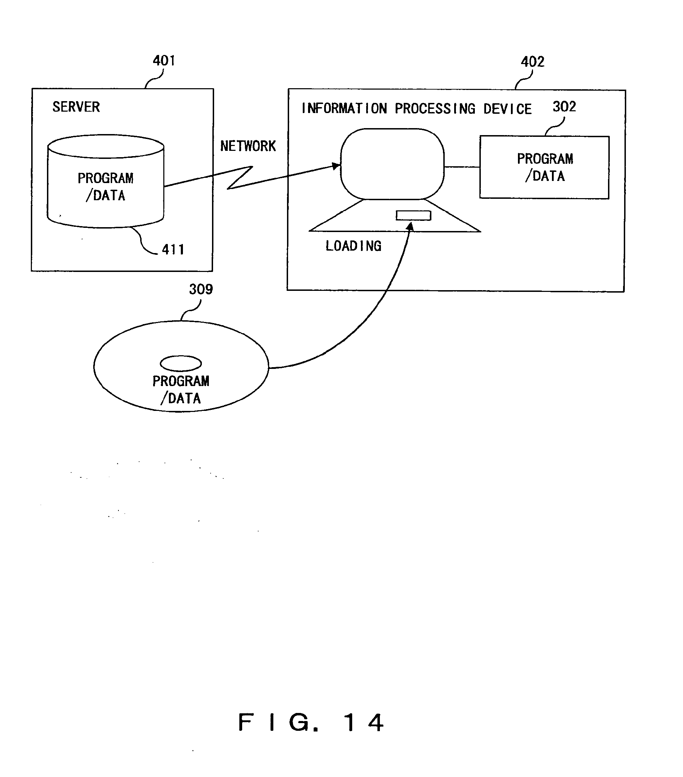

Fig. 14 shows a method for providing the program and the data to the information processing device shown in Fig. 13. The program and the data stored onto the portable recording medium 309 or in a database 411 of a server 401 are loaded into the memory 302 of the information processing device 402. The server 401 generates a propagation signal for propagating the program and the data, and transmits the generated signal to the information processing device 402 via an arbitrary transmission medium on the communications network. The CPU 301 performs necessary processes by executing the program with the data.

**Claims**

1. A remainder calculating apparatus for calculating a remainder left when a polynomial corresponding to an input information string is divided by a generator polynomial, comprising:

   a storing device (51, 104, 106, 205, 207, 209, 211) for storing a plurality of remainder tables which respectively hold values of corresponding remainder information strings by using respective values of a plurality of unit information strings as indexes;
   a table looking-up device (52, 103, 105, 204, 206, 208, 210) for obtaining values of a plurality of remainder information strings by partitioning a target information string, which is processed with a loop process performed once, into a plurality of unit information strings and by referring to the plurality of remainder tables with the use of respective values of the plurality of unit information strings as indexes; and
   a calculating device (53, 107, 203, 212) for calculating an exclusive OR of the obtained plurality of remainder information strings and a first information string of an unprocessed portion of the input information string, wherein said table looking-up device repeats a reference of the plurality of remainder tables a predetermined number of times by using an obtained information string of the exclusive OR as a target information string in a loop process to be performed next.

2. The remainder calculating apparatus according to claim 1, wherein said storing device stores N remainder tables, and an ith remainder table holds M coefficients of a remainder polynomial, which is obtained by dividing p' $(x)$·$x^{M+(N-i)s}$ by the generator polynomial, as a value of a remainder information string corresponding to a value of a unit information string with a length of the unit information string, a length of the remainder information string, and a polynomial of degree of s-1 are s, M, and p'(x) respectively.

3. The remainder calculating apparatus according to claim 1 or 2, further comprising
a register (108) for storing an information string of the exclusive OR, which is obtained by said calculating device, wherein
said calculating device stores an exclusive OR of a plurality of remainder information strings obtained in a last loop process in said register as a remainder calculation result for the input information string.

4. The remainder calculating apparatus according to claim 1 or 2, further comprising
a register (213) for storing an information string of the exclusive OR of the plurality of remainder information strings, wherein
said calculating device calculates an exclusive OR of the first information string and the information string of said register by aligning the strings to beginning, and stores an exclusive OR of the plurality of remainder information strings which is obtained in a last loop process in said register as a remainder calculation result for the input information string.

5. A computer-readable recording medium (302, 305, 309) on which is recorded a program for causing a computer, which calculates a remainder left when a polynomial corresponding to an input information string is divided by a generator polynomial, to execute a process, the process comprising:

    storing a plurality of remainder tables which respectively hold values of corresponding remainder information strings by using respective values of a plurality of unit information strings as indexes;
    obtaining values of a plurality of remainder information strings by partitioning a target information string, which is processed with a loop process performed once, into a plurality of unit information strings and by referring to the plurality of remainder tables with the use of respective values of the plurality of unit information strings as indexes; and
    calculating an exclusive OR of the obtained plurality of remainder information strings and a first information string in an unprocessed portion of the input information string, wherein
    repeating a reference of the plurality of remainder tables a predetermined number of times by using an obtained information string of the exclusive OR as a target information string in a loop process to be performed next.

6. A propagation signal for propagating a program for causing a computer, which calculates a remainder left when a polynomial corresponding to an input information string is divided by a generator polynomial, to execute a process, the process comprising:

    storing a plurality of remainder tables which respectively hold values of corresponding remainder information strings by using respective values of a plurality of unit information strings as indexes;
    obtaining values of a plurality of remainder information strings by partitioning a target information string, which is processed with a loop process performed once, into a plurality of unit information strings and by referring to the plurality of remainder tables with the use of respective values of the plurality of unit information strings as indexes; and
    calculating an exclusive OR of the obtained plurality of remainder information strings and a first information string of an unprocessed portion of the input information string, wherein
    repeating a reference of the plurality of remainder tables a predetermined number of times by using an obtained information string of the exclusive OR as a target information string in a loop process to be performed next.

7. A method for calculating a remainder left when a polynomial corresponding to an input information string is divided by a generator polynomial, comprising:

    storing a plurality of remainder tables which respectively hold values of corresponding remainder information strings by using respective values of a plurality of unit information strings as indexes;
    obtaining values of a plurality of remainder information strings by partitioning a target information string, which is processed with a loop process performed once, into a plurality of unit information strings and by referring to the plurality of remainder tables with the use of respective values of the plurality of unit information strings as indexes; and
    calculating an exclusive OR of the obtained plurality of remainder information strings and a first information string of an unprocessed portion of the input information string, wherein

said obtaining step involves repeatedly referring to the plurality of remainder tables a predetermined number of times by using an obtained information string of the exclusive OR as a target information string in a loop process to be performed next.

PARTIAL REMAINDER CALCULATION (FOR t BITS)

F I G. 1 A

t BITS · M BITS

Q(x)

G(x) : b_0 b_1 b_2 —— b_{t-1} | 0 ————————————— 0

G(x) · Q(x)

r_0 r_1 r_2 —————————— r_{M-1}

F I G. 1 B

F I G. 1 C

F I G. 1 D

INPUT INFORMATION
STRING

↓

| CALCULATING DEVICE | ⌐53 |

REMAINDER
INFORMATION
STRING

TARGET
INFORMATION
STRING

51

| TABLE LOOKING-UP DEVICE |

52

STORING DEVICE

REMAINDER TABLE

REMAINDER TABLE

· ·
·

REMAINDER TABLE

# F I G.  2

F I G. 3

F I G. 4

F I G. 5

t = N·S BITS

S BITS

M BITS

$Q(x) = Q_1(x) + Q_2(x) + \cdots + Q_N(x)$

G(x)

| $p_1$ | $p_2$ | ... | $p_N$ | 0 —————————— 0 |

$G(x) \cdot Q(x)$

R(x)

F I G.  6

F I G. 7

F I G. 8

$$Q_N(x)$$

$$G(x)$$

| $p_N$ | 0 —————————— 0 |

| $G(x) \cdot Q_N(x)$ |

| $R_N(x)$ |

# F I G. 9

K BITS

t BITS | M BITS

$Q(x) = Q_1(x) + Q_2(x) + \cdots + Q_N(x)$

$G(x)$

$b_0 \ b_1 \ b_2 \ \rule{3cm}{0.4pt} \ b_{t-1}$ | $b_t \ \rule{2cm}{0.4pt} \ b_{t+M-1}$ | $b_{t+M} \ \rule{3cm}{0.4pt} \ b_{K-1}$

$G(x) \cdot Q(x)$

$P'(x) =$ | $b'_t \ \rule{1.5cm}{0.4pt} \ b'_{t+M-1}$ | $b_{t+M} \ \rule{3cm}{0.4pt} \ b'_{K-1}$

$R'(x)$

F I G.  1 0 A

EP 1 873 920 A1

FIG. 10B

F I G. 1 1

F I G. 1 2

BUS

301

CPU

308

302

MEMORY

303

INPUT
DEVICE

304

OUTPUT
DEVICE

305

EXTERNAL STORAGE
DEVICE

306

MEDIUM DRIVING
DEVICE

309

PORTABLE
RECORDING MEDIUM

307

NETWORK CONNECTING
DEVICE

NETWORK

F I G. 13

**401** **402**

**SERVER** **INFORMATION PROCESSING DEVICE** **302**

**NETWORK** **PROGRAM /DATA**

**PROGRAM /DATA**

**LOADING**

**411**

**309**

**PROGRAM /DATA**

F I G. 1 4

**European Patent Office**

# EUROPEAN SEARCH REPORT

Application Number

EP 06 25 5310

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 619 516 A (LI SHIPING [US] ET AL) 8 April 1997 (1997-04-08) <br> * abstract * <br> * column 3, line 43 - column 5, line 1 * <br> * column 5, line 65 - column 6, line 4 * <br> * column 8, line 17 - line 56 * <br> * column 10, line 16 - column 11, line 36 * <br> * figures 5,7 * | 1-7 | INV. <br> H03M13/09 |
| X <br><br> A | US 6 195 780 B1 (DRAVIDA SUBRAHMANYAM [US] ET AL) 27 February 2001 (2001-02-27) <br> * abstract * <br> * column 3, line 33 - column 5, line 15 * <br> * column 6, line 4 - line 31 * <br> * column 7, line 8 - column 8, line 58 * <br> * figure 3 * | 1,2,4-7 <br><br> 3 | |
| X | US 2004/250193 A1 (CAVANNA VICENTE V [US] ET AL) 9 December 2004 (2004-12-09) <br> * abstract * <br> * paragraph [0101] - paragraph [0114] * <br> * paragraph [0124] - paragraph [0134] * <br> * figures 3,4 * | 1-7 | TECHNICAL FIELDS SEARCHED (IPC) <br><br> H03M |
| X <br><br><br><br><br><br> A | ANONYMOUS: "Method for CRC generation using remainder slicing and parallel table lookups" <br> IP.COM JOURNAL, IP.COM INC., WEST HENRIETTA, NY, US, <br> 23 March 2005 (2005-03-23), XP013023977 <br> ISSN: 1533-0001 <br> * the whole document * | 1,5-7 <br><br><br><br><br><br> 2-4 | |

-/--

The present search report has been drawn up for all claims

| Place of search | Date of completion of the search | Examiner |
|---|---|---|
| Munich | 28 December 2006 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 06 25 5310

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GRIFFITHS G ET AL: "THE TEA-LEAF READER ALGORITHM: AN EFFICIENT IMPLEMENTATION OF CRC-16 AND CRC-32" COMMUNICATIONS OF THE ASSOCIATION FOR COMPUTING MACHINERY, ACM, NEW YORK, NY, US, vol. 30, no. 7, July 1987 (1987-07), pages 617-620, XP000719762 ISSN: 0001-0782 | 1,5-7 | |
| A | * page 617 * <br> * figure 1 * | 2-4 | |
| A | WO 99/37030 A (3COM CORP [US]; DESJARDINS PHILIP A [US]; MANTRI RAVI G [US]) 22 July 1999 (1999-07-22) * page 7 - page 14; figures 3,5 * | | |
| A | SARWATE D V: "COMPUTATION OF CYCLIC REDUNDANCY CHECKS VIA TABLE LOOK-UP" COMMUNICATIONS OF THE ASSOCIATION FOR COMPUTING MACHINERY, ACM, NEW YORK, NY, US, vol. 31, no. 8, 1 August 1988 (1988-08-01), pages 1008-1013, XP000003858 ISSN: 0001-0782 * the whole document * | 1-7 | TECHNICAL FIELDS SEARCHED (IPC) |

The present search report has been drawn up for all claims

| Place of search | Date of completion of the search | Examiner |
|---|---|---|
| Munich | 28 December 2006 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 25 5310

This annex lists the patent family members relating to the patent documents cited in the above-mentioned European search report.
The members are as contained in the European Patent Office EDP file on
The European Patent Office is in no way liable for these particulars which are merely given for the purpose of information.

28-12-2006

| Patent document cited in search report | | Publication date | Patent family member(s) | | Publication date |
|---|---|---|---|---|---|
| US 5619516 | A | 08-04-1997 | AU | 659971 B2 | 01-06-1995 |
| | | | AU | 5846394 A | 19-07-1994 |
| | | | CA | 2129236 A1 | 07-07-1994 |
| | | | EP | 0631703 A1 | 04-01-1995 |
| | | | JP | 7504312 T | 11-05-1995 |
| | | | WO | 9415407 A1 | 07-07-1994 |
| US 6195780 | B1 | 27-02-2001 | NONE | | |
| US 2004250193 | A1 | 09-12-2004 | GB | 2402582 A | 08-12-2004 |
| | | | JP | 2005006298 A | 06-01-2005 |
| WO 9937030 | A | 22-07-1999 | AU | 2325699 A | 02-08-1999 |
| | | | US | 6029186 A | 22-02-2000 |

For more details about this annex : see Official Journal of the European Patent Office, No. 12/82

**EP 1 873 920 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005006188 A

- WO 2003090362 A